# EUROPÄISCHE PATENTSCHRIFT

(11) **EP 0 471 108 B1**
(45) Veröffentlichungstag und Bekanntmachung des Hinweises auf die Patenterteilung: **08.03.1995**
(21) Anmeldenummer: 90115755.2
(22) Anmeldetag: 17.08.1990
(51) Int. Cl.: G01R 27/28, G01R 27/06

(54) **Breitbandiges System zur Netzwerkanalyse**
Broad band system for network analysis
Système d'analyse de réseau à bande large

(43) Veröffentlichungstag der Anmeldung: 19.02.1992
(73) Patentinhaber: Ballmann, Ralf, 91080 Marloffstein (DE)
(72) Erfinder: Ballmann, Ralf, 91080 Marloffstein (DE)
(74) Vertreter: Hafner, Dieter, Dr.rer.nat., Dipl.-Phys.

(56) Entgegenhaltungen:
- EP-A- 0 261 828
- WO-A-88/08211
- GB-A- 2 209 841
- US-A- 4 808 913
- TE - TOUTE L'ELECTRONIQUE Nr. 530, Januar 1988, Seiten 64-71, Paris, FR; M. Roussel: "Nouvelles de réseau"
- TE - TOUTE L'ELECTRONIQUE Nr. 500, Januar 1985, Seiten32-37, Paris, FR; J.G. HERVIAULT: "L'analyse de réseau hyperfréquences"
- ELEKTRONIK Band 39, Nr. 4, 16. Februar1990, Seiten 116-121, München, DE; B. SCHWEIGER: "Vektorielle Netzwerk-Messungen: Grundlagen und Anwendungen"

## Beschreibung

Die Erfindung betrifft ein breitbandiges Meßsystem zur Netzwerkanalyse mit den Merkmalen des Oberbegriffs des Patentanspruches 1.

### Stand der Technik:

Aus einem Datenblatt der Firma "Hewlett Packard" zu den Geräten HP 8756 A und 8757 A (skalare Netzwerkanalysatoren) ist ein breitbandiges Meßsystem bekannt, das zunächst einen elektronisch durchstimmbaren Hochfrequenzwobbelgenerator mit mindestens einem Hochfrequenzausgang aufweist. Sodann gehört zu dem als Stand der Technik beschriebenen System ein sog. skalarer Netzwerkanalysator (Skalar Network Analyzer), der neben einem Referenzsignaleingang mindestens einen ersten Meßkanaleingang aufweist. Der dargestellte skalare Netzwerkanalysator weist neben dem ersten Meßkanaleingang noch weitere Meßkanaleingänge auf.

Sodann ist in dem genannten Datenblatt eine Schaltungsanordnung dargestellt, die mit koaxialen Verbindungselementen wie Kabeln, Steckern und dergleichen zwischen den Ausgang des Hochfrequenzgenerators und die Eingänge des Netzwerkanalysators geschaltet ist und eine Verteilerschaltung enthält, deren Eingang mit dem Ausgang des HF-Wobbelgenerators verbunden ist und die zwei Ausgangsanschlüsse aufweist, deren erster mit dem Referenzsignaleingang des skalaren Netzwerkanalysators verbunden ist.

Weiterhin ist eine Meßbrücke mit Richtwirkungseigenschaften vorgesehen, deren Ein- und Ausgänge unterschiedlich entkoppelt sind und deren Eingang mit einem Ausgang der Verteilerschaltung verbunden ist und deren erster Ausgang zu einem zu vermessenden Objekt, beispielsweise einem Bandpaß oder dergleichen geführt ist.

Die dargestellte Verteilerschaltung wird durch einen sog. Leistungsteiler gebildet, im einzelnen ist der Leistungsteiler ein resistiver 6dB Stern, wobei Ein/Ausgänge dieses 6 dB Sterns gegeneinander Vor-Rückdämpfungen von jeweils 6 dB aufweisen.

Dies führt in nachteiliger Weise dazu, daß die vom Meßobjekt zurücklaufende Welle aufgrund der Dämpfungseigenschaften des Leistungsteilers nach dem Stand der Technik Einfluß auf den Referenzeingang nimmt, das Referenzsignal am Generator wird verfälscht, bei einer beeinflussten, verfälschten Referenz ist eine exakte Messung der Transmissions- und Reflektionseigenschaften des Meßobjektes nicht mehr exakt durchführbar.

Bei diesem Stand der Technik ist man dazu übergangen, zwischen dem Meßobjekt und dem Meßtor zusätzlich ein Dämpfungsglied einzusetzen. Derartige Maßnahmen sind allerdings immer dann nachteilig, wenn es erforderlich ist, die Messung im gesamten zur Verfügung stehenden Dynamikbereich durchzuführen. Bei skalaren Systemen ist die Anordnung eines Dämpfungsgliedes ohnehin nicht mehr möglich, da keine phasenbehaftete Fehlerkorrektur möglich ist.

Weiterhin ist aus der vorbezeichneten Broschüre der Firma "Hewlett Packard" ein Hohlleiter-Meßsystem für den Milimeterwellenbereich bekannt, bei dem die HF-Auskopplung über zwei "Richtkoppler" erfolgt. Jedoch können zum einen die Verhältnisse in Hohlleitermeßsystemen nicht ohne weiteres mit denen in Koaxialsystemen verglichen werden, darüber hinaus ergibt sich aus dem vorveröffentlichten Hohlleitersystem und dem Einsatz zweier gleicher Bauelemente der "Richtkoppler" keinerlei Anregung in Koaxialsystemen den Referenzzweig vom Meßobjekt mehr oder weniger völlig zu entkoppeln.

Der Erfindung liegt die Aufgabe zugrunde, ein breitbandiges Meßsystem mit den Merkmalen des Oberbegriffs des Anspruches 1 derart weiterzubilden, daß die Güte des Referenzzweiges von der Anpassung des Meßobjektes unabhängig wird, der Referenzzweig soll vom Meßobjekt mehr oder weniger völlig abgekoppelt sein, um jegliche Einflußnahme einer nicht optimierten Anpassung des Meßobjektes an die Brückeneigenschaften und damit negative Einflußnahme auf den nachfolgenden Referenzzweig auszuschließen.

Diese Aufgabe wird durch die kennzeichnenden Merkmale der Anspruches 1 gelöst. Vorteilhafte Weiterbildungen ergeben sich aus den nachfolgenden Unteransprüchen.

Bei der Erfindung wird nun als Verteilerschaltung eine weitere Meßbrücke eingesetzt, die wie die bereits im System vorhandene Meßbrücke Richtwirkungseigenschaften haben soll. Die Richtwirkungeigenschaften sind so vorzusehen, daß die beiden Ausgangsanschlüsse gegeneinander hochentkoppelt sind vergleichsweise zu den Entkopplungen zwischen dem Eingang und den jeweiligen Ausgängen. Die Rückdämpfung der vom Meßobjekt bei nicht optimaler Anpassung reflektierten Welle in den Referenzzweig läßt sich durch die erfindungsgemäßen Maßnahmen um mindestens zwei Größenordnungen verbessern, darüber hinaus wirkt sich besonders vorteilhaft an der Erfindung aus, daß gleiche Bauteile in Koaxialtechnik symmetrisch innerhalb eines Meßkopfes eingesetzt werden können und damit eine Verbesserung der Phasenstabilität der gesamten Anordnung erzielbar ist. Ein weiterer Vorteil ist, daß beim Aufbau des Meßkopfes jeweils eine Meßbrücke höchster Güte als "Meßbrücke im eigentlichen Sinn" und eine weitere Meßbrücke mit weniger hoher Güte (Ausschußmeßbrücke) verwendet werden kann, da die weniger optimierte Güte der als Verteilerschaltung eingesetzten Meßbrücke keine nachteiligen Auswirkungen auf das Meßergebnis hat. Somit lassen sich in besonders vorteilhafter und sparsamer Weise auch weniger gut optimierte Meßbrücken sinnvoll in höchst qualifizierten Systemen einsetzen.

Besonders vorteilhaft ist es, wenn die beiden Meßbrücken der Schaltungsanordnung i. w. identisch sind, d. h. gleiche Richtwirkungseigenschaften haben, die Entkopplungen zwischen den Ein-/Ausgängen können beispielsweise 46 dB/8dB/6dB aufweisen, dies sind Werte, wie sie beispielsweise bei einer mit ZRB 2 bezeichneten Meßbrücke der Firma Rohde und Schwarz üblich sind. Zwei derartige ZRB 2 -Meßbrücken können nebeneinander mit unterschiedlicher Aufgabenverteilung eingesetzt werden.

Der zweite Ausgang der Meßbrücke kann direkt zu einem weiteren Meßkanaleingang des skalaren Netzwerkanalysators geführt werden, der erste Meßkanaleingang ist direkt mit dem Meßobjekt zur Transmissionsmessung verbunden.

Besonders vorteilhaft ist es, wenn die beiden Meßbrücken mit weiteren Bauteilen fest in einem gemeinsamen Gehäuse, nämlich einem Meßkopfgehäuse eingebaut sind. Das Gehäuse muß mindestens einen Meßausgang aufweisen, der sich dann im wesentlichen direkt an das Meßobjekt anschließen läßt.

Besonders vorteilhaft auf die Phasenstabilität und damit auf die Qualität des Meßkopfes wirkt es sich aus, wenn sämtliche im Gehäuse angeordneten Bauteile, nämlich die Bauteile der beiden Meßbrücken sowie die weiteren in dem Meßkopfgehäuse angeordneten Bauteile bezogen auf eine Mittellängsebene einer die Bauteile tragenden Platine symmetrisch angeordnet werden. Derartige symmetrische Anordnungen sind - was Fehlerquellen anbelangt -leichter beherrschbar als unsymmetrisch aufgebaute Anordnungen. Da in einem solchen Meßkopf eine Frequenzumsetzung nach dem sog. Überlagerungsverfahren eingesetzt werden kann, ist es möglich, die Phasenfehler, die z. B. durch flexible Kabel zwischen Meßkopf und Netzwerkanalysator geschaltet sind, verursacht werden können, weitestgehend auszuschließen. Dies ist dann der Fall, wenn über solche Kabel nur tiefe Frequenzen, die sog. Zwischenfrequenz von beispielsweise 100 kH geführt wird. Kabel bewirken nämlich Laufzeitfehler, die sich bei hohen Frequenzen störender auf die Phase auswirken als bei tiefen Frequenzen. Es besteht jeweils eine Phasenbeziehung zwischen dem Eingangssignal 181 zum Signal 165′ der Brücke 120 und einer Phasenbeziehung zum Signal 165 der Brücke 130. Da beide Phasenbeziehungen sich aus dem Signal 181 herleiten, besteht auch eine definierte Beziehung zwischen den beiden Ausgangssignalen 172 und 172′. Aufgrund der im Meßkopf stattfindenden Frequenzumsetzung ergeben sich für die Phasenbeziehungen zwischen den beiden Ausgängen 172 und 172′ um mehrere Größenordnungen kleinere Phasenfehler als bei nicht-frequenzumgesetzter Verarbeitung, wie sie beispielsweise beim Stand der Technik üblich ist. Wenn hier von Phasenfehlern am Ausgang gesprochen wird, so sind damit die Phasenfehler gemeint, die letztlich dann nach der Übertragung zum Netzwerkanalysator am Netzwerkanalysatoreingang anliegen.

Weiterhin betrifft die Erfindung noch einen Meßkopf für ein derartiges breitbandig messendes System zur Netzwerkanalyse, der dadurch gekennzeichnet ist, daß er zwei im wesentlichen identisch aufgebaute Meßbrücken mit Richtwirkungseigenschaften enthält, wobei die eine Meßbrücke ausgangsseitig mit einem zu messenden Objekt und die andere Meßbrücke eingangsseitig mit dem HF-Ausgang eines durchstimmbaren HF-Wobbel-Generators und mit ihren Ausgängen einerseits am Referenzeingang eines Netzwerk Analysators und andererseits mit dem Eingang der ersten Meßbrücke verbunden ist. Ein derartiger Meßkopf ist problemlos handhabbar und hat die elektronischen Eigenschaften die oben bereits anhand des Gesamtsystemes geschildert worden sind. Darüber hinaus wirkt es sich besonders vorteilhaft aus, wenn gemäß Anspruch 14 alle Verbindungselemente wie Kabel und dergleichen in dem Meßkopfgehäuse fixiert sind. Werden nämlich Kabel bei der Messung beeinflußt und dadurch unter Umständen bewegt, ergeben sich bei hochempfindlichen Messungen Phasenverschiebungen, die das Meßergebnis verfälschen können. Durch die Eingliederung der als Meßbrücke ausgebildeten Verteilerschaltung zusammen mit der eigentlich wirksamen Meßbrücke in ein gemeinsames Gehäuse unter Ausnutzung der hohen Entkoppeldämpfung im Referenzzweig und dem symmetrischen Aufbau ergeben sich für den beanspruchten Meßkopf hervorragende Qualitätswerte.

Die Erfindung von Zeichnungsfiguren näher erläutert:

Diese zeigen:
- Fig. 1: ein breitbandiges Meßsystem zur Netzwerkanalyse nach dem Stand der Technik;

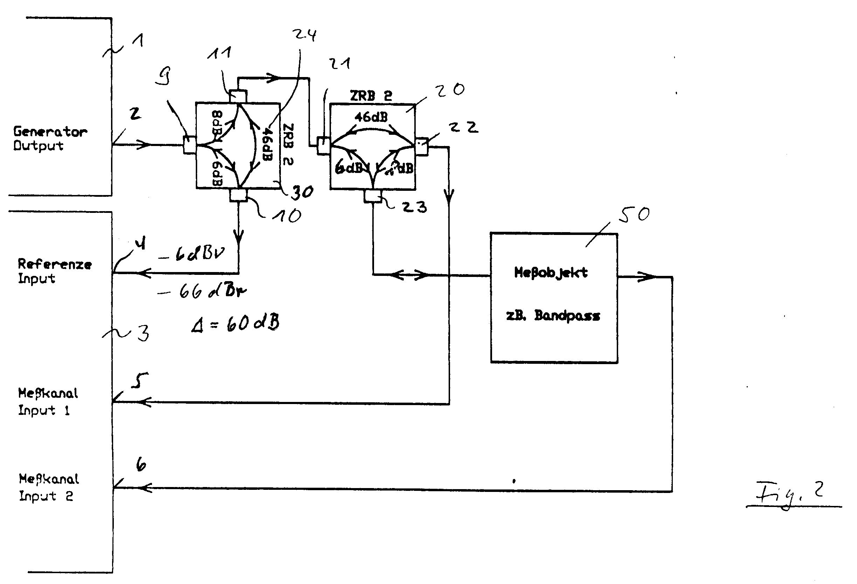

- Fig. 2: ein breitbandiges Meßsystem zur Netzwerkanalyse, bei dem die Verteilerschaltung durch eine zur verwendeten Meßbrücke identische weitere Meßbrücke gebildet wird;
und
- Fig. 3: den schematischen elektronischen Aufbau eines Meßkopfes nach der Erfindung.

Unter Bezugnahme auf Zeichnungsfigur 1 wird zunächst ein breitbandiges Meßsystem zur Netzwerkanalyse nach dem Stand der Technik vorgestellt.

Zunächst ist ein elektronisch durchstimmbarer HF-Wobbel-Generator 1 vorgesehen, der einen Ausgang 2 aufweist. Ein Netzwerkanalysator 3 ist mit einem Referenzsignaleingang 4 und Meßkanaleingängen 5 und 6 versehen.

Zwischen die vorstehend bezeichneten Komponenten ist mit koaxialen Verbindungselementen wie Kabeln, Steckern und dergleichen eine Schaltungsanordnung gelegt, die insgesamt mit 7 bezeichnet wird. Die Schaltungsanordnung 7 enthält eine Verteilerschaltung (Leistungsteiler) in Form eines sog. 6dB Sternes, deren Eingang 9 mit dem Ausgang 2 des HF-Wobbel-Generator verbunden ist. Der 6 dB Stern sieht zwei Ausgangsanschlüsse 10 und 11 vor, wobei der Ausgangsanschluß 10 mit dem Referenzsignaleingang 4 des skalaren Netzwerkanalysator verbunden ist und der Ausgang 11 auf den ersten der einen Ausgangsanschlüsse 21 einer Meßbrücke 20 mit Richtwirkungseigenschaften angeschlossen ist. Bedeutungsvoll an der Meßbrücke 20 mit Richtwirkungseigenschaften ist, daß ihre Ein/Ausgänge 21, 22 und 23 unterschiedlich entkoppelt sind, derartige Meßbrücken gehören zum Stand der Technik und werden unter der Bezeichnung "ZRB 2" von Fa. "Rohde und Schwarz vertrieben. Die Dämpfung zwischen dem Anschluß 21 und 22 beträgt beispielsweise 46 dB, die Dämpfung zwischen dem Anschluß 21 und 23 6 dB und die Dämpfung zwischen dem Anschluß 22 und 23 8 dB. Derartige Meßbrücken dienen zur Messung des Reflektionsfaktors nach Betrag und Phase z. B. von Filtern, Verstärkern, Kabel, Verteiler, Mischern, Antennen usw. Das von HF-Generatorausgang kommende Signal gelangt über die Meßbrücke zum Meßobjekt, abhängig von dessen Reflektionsfaktor wird ein Teil des Signals über die Meßbrücke zurück zum eigentlichen Meßgerät reflektiert. Dieser Teil B des Signals ist ein Maß für den komplexen Reflekionsfaktor des Meßobjekts, es ist möglich, den gemessenen Reflektionsfaktor in andere Parameter umzurechnen, beispielsweise in Impedanz oder die Admittanz des Meßobjektes. Dabei ist sowohl die Darstellung nach Betrag und Phase wie auch nach Real und Imaginärteil möglich. (Die Meßbrücke ZRB 2, die hier beschrieben wird, wird von Firma Rode & Schwarz GmbH & Co. KG, D-8000 München 80 unter dem Datenblatt 335281 beworben).

Das Meßobjekt, das z. B. ein Filter, Verstärker, Mischer oder Antenne sein kann ist an Ausgang 23 angeschlossen, die vom Ausgang 2 des HF-Wobbel-Generators kommenden Signale erfahren sowohl in dem 6 dB Stern als auch in der Meßbrücke Vorwärts- (dBv-Werte) und Rückwärtsdämpfungen (dBr-Werte) (dBv= Dämpfung der vorlaufenden Well, dBr= Dämpfung der rücklaufenden Welle), die sich wie folgt darstellen:

Am Ausgang 11 des 6 dB Sternes liegt eine Dämpfung von + 6dbv vor, am Ausgang 23 der Brücke 20 eine Dämpfung von + 12dBv. Die rücklaufende Welle ist zwischen den Anschlüssen 11 und 21 + 6dBr gedämpft, zusammen mit dem Dämpfungsfaktor von 6dB innerhalb des 6dB Sterns zwischen den Ausgängen 11 und 10 liegt insgesamt eine Dämpfung von + 12 dBr am Referenzeingang 4 vor.

Aus der Summe der Vorwärtsdämpfung 12dBv und der Rückwärtsdämpfung 12dBr sowie unter Berücksichtigung der 6dB Dämpfung zwischen dem Eingang 9 und dem Ausgang 10 des 6dB Sterns ergibt sich insgesamt ein Verhältnis der Dämpfungen der vorlaufenden und rücklaufenden Welle von 18 dB. Eine derartige Dämpfung ist nicht geeignet, im Falle einer Flächenanpassung des Meßobjektes Verfälschungen des Referenzsignales zu vermeiden, die von der rücklaufenden Welle herrühren.

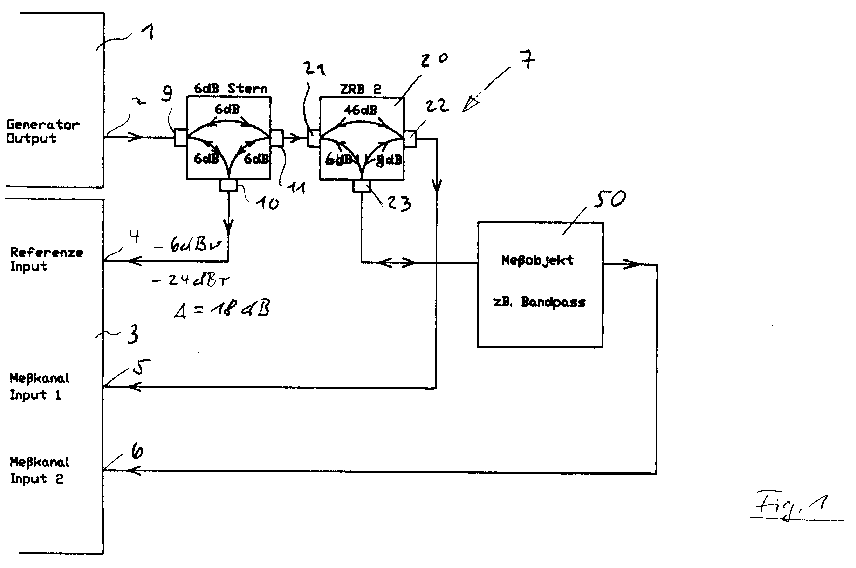

Zur abschließenden Erläuterung der Fig. 1 sei noch erwähnt, daß Meßkanaleingang 6 mit dem Meßobjekt 50 verbunden sein kann, um auch die Transmissionseigenschaften des Meßobjektes zu erfassen.

Zeichnungsfigur 2 gibt nun die Erfindung wieder, wobei gleiche Bezugszahlen in den Zeichnungsfiguren 1 und 2 gleiche technische Elemente bezeichnen.

Bedeutungsvoll ist als Unterschied, daß der 6 dB Stern, der als Leistungsteiler gemäß Fig .1 eingesetzt wird, durch eine zweite Meßbrücke 30 mit Richtwirkungseigenschaften ersetzt ist, wobei die hohe Entkopplung im Falle der Meßbrücke ZRB 2 von 46 dB, zwischen die Ausgänge 10 und 11 gelegt ist. Dadurch ergibt sich in besonders vorteilhafter Weise eine Entkopplung des Referenzsignales von Störungen die auf einer nicht optimalen Anpassung des Meßobjektes an die Schaltungsanordnung herrühren.

Im Vergleich zu dem Stand der Technik gemäß Fig. 1 ergibt sich am Referenzsignaleingang eine Dämpfung der vor- und rücklaufenden Welle von 66 dB, d. h. die Differenz zwischen der Vorwärtsdämpfung am Referenzeingang von + 6dB und der vorstehend benannten Dämpfung von + 66dBr eine Differenz von △ 60dB, die die Koppeldämpfung in diesem System darstellt. Verglichen mit den △ 18dB nach dem Stand der Technik wird hiermit eine Verbesserung der Abkopplung des Referenzzweiges um mehrere Größenordnungen erreicht, so daß eine Verfälschung der Meßergebnisse durch Referenzsignalverfälschungen so gut wie ausgeschlossen ist.

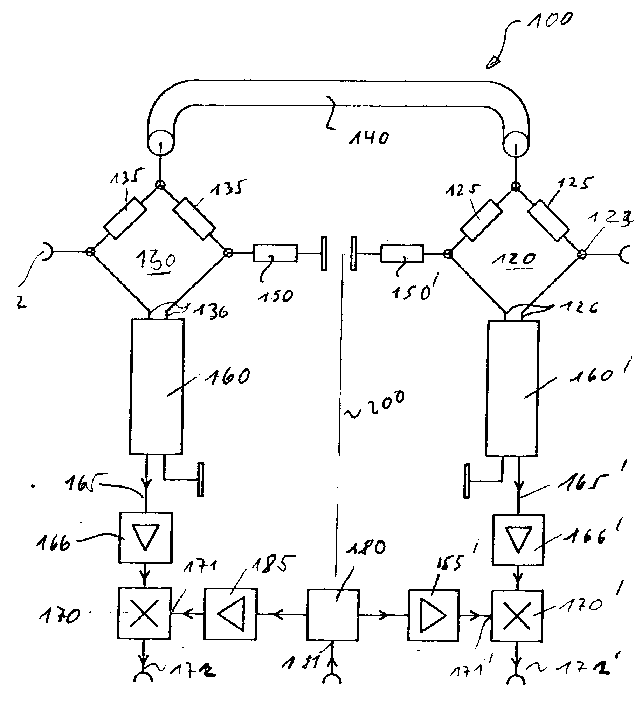

Fig. 3 zeigt nun dem schematischen Aufbau eines Meßkopfes, der die erfindungsgemäße Schaltung enthält.

Der insgesamt mit 100 bezeichnete Meßkopf enthält zunächst zwei Meßbrücken 120, 130, wobei die Meßbrücke 130 an den Generatorausgang 2 angeschlossen ist und somit als Verteilerschaltung fungiert. An den Ausgang 123 der Meßbrücke 120 ist ein nicht weiter dargestelltes Meßobjekt anschließbar.

Die beiden Meßbrücken 120, 130 sind mit jeweils zwischen den Brückenwiderständen 125 bzw. 135 liegenden Anschlüssen über eine Koax-Verbindung 140 querverbunden.

Die Referenzwiderstände 150, 150′ die an Masse gelegt sind, können beispielsweise dem Wellenwiderstand im System entsprechen, in dem gerade gemessen wird.

Mit Anschlüssen 136 bzw. 126 sind die Meßbrücken 130 bzw. 120 an sog. Symmetrieübertrager 160, 160′ angeschlossen, um aus den zwischen den Anschlüssen 126 bzw. 136 liegenden symmetrischen Signalen in auf Masse bezogene unsymmetrische Signale zu transformieren.

Diese unsymmetrischen Signale, die an den Leitungen 165, 165′ vorliegen, werden über sog. Isolationsverstärker 166, 166′, zwei Mischern 170, 170′ zugeleitet. An den Treibereingängen 171, 171′ der beiden Mischer 170, 170′ liegen die Ausgänge eines resistiven Leistungsteilers 180 an (dies kann wiederum ein 6dB Stern sein) zwischen die Ausgänge des Leistungsteiler 180 und die Treibereingänge 171, 171′ sind zwei Isolationsverstärker 185, 185′ geschaltet, um die Ausgänge des resistven Leistungsteiler 180 zu entkoppeln.

An den Mischerausgängen 172 bzw. 172′ liegen dann die ZF-Ausgangssignale 1 bzw. 2 an, die in üblicher Weise von dem Netzwerkanalysator verarbeitet werden können.

Sämtliche Bauteile innerhalb des Meßkopfes können auf einer nicht-dargestellten Platine angeordnet sein, bezogen auf die Mittel-Längsebene 200 der Platine herrscht Symmetrie vor. Ferner sind alle Kabelverbindungen und dergleichen im Meßkopfgehäuse 40 so fixiert, daß sie mechanisch nicht bewegt werden können.

## Patentansprüche

1. Breitbandiges Meßsystem zur Netzwerkanalyse mit
- einem elektronisch durchstimmbaren HF-Wobbel-Generator (1 ) mit mindestens einem Ausgang (2),
- einem Netzwerkanalysator (3), der
-- neben einem Referenzsignaleingang (4) mindestens einen ersten (5), gegebenenfalls weitere Meßkanaleingänge (6) aufweist und
- einer Schaltungsanordnung (7),
-- die mit koaxialen Verbindungselementen (Kabeln, Stecker und dergleichen) zwischen den Ausgang (2) des HF-Generators (1) und die Eingänge (4,5,6) des Netzwerkanalysators (3) geschaltet ist, sowie
-- eine Verteilerschaltung enthält, deren Eingang (9) mit dem Ausgang (2) des HF-Generators (1) verbunden ist und die zwei Ausgangsanschlüsse (10, 11)aufweist, deren erster mit dem Referenzsignaleingang (4) des Netzwerkanalysators (3) verbunden ist
-- und zudem eine erste Meßbrücke (20) mit Richtwirkungseigenschaften enthält, deren Ein/Ausgänge (21, 22, 23) unterschiedlich entkoppelt sind, deren Eingang (21) mit einem Ausgang (11) der Verteilerschaltung verbunden ist und deren erster Ausgang (23) zu einem Meßobjekt (50), beispielsweise einem Bandpaß, geführt ist,
dadurch gekennzeichnet,
daß
- die Verteilerschaltung durch eine zweite Meßbrücke (30) mit Richtwirkungseigenschaften gebildet wird, deren hohe Entkopplung (24) zwischen den beiden Ausgangsanschlüssen (10, 11) liegt.

2. Meßsystem nach Anspruch 1,
dadurch gekennzeichnet,
daß die beiden Meßbrücken (20, 30) der Schaltungsanordnung (7) gleiche Richtwirkungseigenschaften haben.

3. Meßsystem nach einem der vorhergehenden Ansprüche 1 und 2,
dadurch gekennzeichnet,
daß die Entkopplungen zwischen den Aus/Eingängen der beiden Meßbrücken (20, 30) jeweils 46dB/8dB/6dB betragen.

4. Vorrichtung nach einem der vorhergehenden Ansprüche,
dadurch gekennzeichnet,
daß ein zweiter Ausgang (22) der ersten Meßbrücke (20) zu dem weiteren Meßkanaleingang (5) des Netzwerkanalysators (3) geführt ist.

5. Meßsystem nach einem der vorhergehenden Ansprüche,
dadurch gekennzeichnet,
daß die beiden Meßbrücken (20, 30, 120, 130) gegebenenfalls mit weiteren Bauteilen in einem gemeinsamen Gehäuse (40) angeordnet sind.

6. Meßsystem nach Anspruch 5,
dadurch gekennzeichnet,
daß das Gehäuse (40) mindestens einen Meßausgang (123) aufweist, der direkt an das Meßobjekt (50) anschließbar ist.

7. Meßsystem nach einem der vorhergehenden Ansprüche
dadurch gekennzeichnet,
daß sämtliche Bauteile der beiden Meßbrücken (120, 130) sowie die weiteren in dem Meßkopfgehäuse angeordneten Bauteile bezogen auf eine Mittellängsebene (200) einer die Bauteile tragenden Platine symmetrisch angeordnet sind.

8. Meßsystem nach einem der vorhergehenden Ansprüche
dadurch gekennzeichnet,
daß die Brückenwiderstände (125, 135) der beiden Meßbrücken (120, 130) jeweils identische Widerstandswerte haben.

9. Meßsystem nach einem der vorhergehenden Ansprüche,
dadurch gekennzeichnet,
daß die Referenzwiderstände (150) dem Wellenwiderstand des zu messenden Systems (50) entsprechen.

10. Meßsystem nach einem der vorhergehenden Ansprüche,
dadurch gekennzeichnet,
daß die beiden Meßbrücken (20, 30, 120, 130) zur Umwandlung Ihrer symmetrischen Ausgangs-Signale in jeweils unsymmetrische, auf Masse bezogene Signale mit Symmetrieübertragern (160) verbunden sind, deren Ausgangsleitungen (165) mit den Meßkanaleingängen verbunden sind.

11. Meßsystem nach Anspruch 10,
dadurch gekennzeichnet,
daß zur Rückwärtsisolation zwischen Meßbrücken (120, 130) und weiterverarbeitenden Schaltelementen Isolationsverstärker (166) geschaltet sind.

12. Meßsystem nach einem der vorhergehenden Ansprüche,
dadurch gekennzeichnet,
daß die Ausgänge der Isolationsverstärker (166) zu Mischern (170) geführt sind, deren treibende Eingänge (171) gegebenenfalls über weitere Isolationsverstärker (185) mit den Ausgängsanschlüssen eines resistiven Leistungsteilers (180) verbunden sind, dessen Eingang (181) mit einer um eine Zwischenfrequenz versetzte Frequenz beaufschlagt wird.

13. Meßkopf für ein breitbandig messendes System zur Netzwerkanalyse
dadurch gekennzeichnet,
daß er zwei identisch aufgebaute Meßbrücken (120, 130) mit Richtwirkungseigenschaften enthält, wobei die eine Meßbrücke (120) ausgangsseitig mit einem zu messenden Objekt und die andere Meßbrücke (130) eingangsseitig mit dem HF-Ausgang eines durchstimmbaren HF-Wobbel-Generators (1) und mit ihren Ausgängen einerseits mit Referenzeingang eines Netzwerkanalysators, andererseits mit dem Eingang der ersten Meßbrücke verbunden ist.

14. Meßkopf nach Anspruch 13,
dadurch gekennzeichnet,
daß alle Verbindungselemente wie Kabel (100), Streifenleitungen und dergleichen in dem Meßkopfgehäuse fixiert sind.

## Claims

1. Broadband measuring system for network analysis having:
- an electronically tunable high-frequency sweep generator (1) with at least one output (2);
- a network analyser (3) which:
- in addition to a reference signal input (4) comprises at least one first (5) and possibly further measuring channel inputs (6); and
- a circuit arrangement (7):
- which is connected with coaxial connecting elements (cables, plugs and the like) between the output (2) of the high-frequency generator (1) and the inputs (4, 5, 6) of the network analyser (3); and
- which contains a divider circuit of which the input (9) is connected to the output (2) of the high-frequency generator (1) and which comprises two output connections (10, 11) of which the first is connected to the reference signal input (4) of the network analyser (3);
- and which in addition contains a first measuring bridge (20) having directivity properties of which the in/outputs (21, 22, 23) are decoupled differently, of which the input (21) is connected to an output (11) of the divider circuit and of which the first output (23) is guided to an object being measured (50), for example a bandpass;
characterised in that:
- the divider circuit is formed by a second measuring bridge (30) having directivity properties of which the high decoupling (24) lies between the two output connections (10, 11).

2. Measuring system according to Claim 1, characterised in that the two measuring bridges (20, 30) of the circuit arrangement (7) have the same directivity properties.

3. Measuring system according to either of the preceding Claims 1 and 2, characterised in that the decouplings between the out/inputs of the two measuring bridges (20, 30) are 46dB/8dB/6dB respectively.

4. Apparatus according to any one of the preceding claims, characterised in that a second output (22) of the first measuring bridge (20) is guided to the further measuring channel input (5) of the network analyser (3).

5. Measuring system according to any one of the preceding claims, characterised in that the two measuring bridges (20, 30, 120, 130) are if necessary disposed with further components in a common housing (40).

6. Measuring system according to Claim 5, characterised in that the housing (40) comprises at least one measuring output (123) which can be connected directly to the object being measured (50).

7. Measuring system according to any one of the preceding claims, characterised in that all the components of the two measuring bridges (120, 130) and the further components disposed in the measuring head housing are disposed symmetrically relative to a central longitudinal plane (200) of a board supporting the components.

8. Measuring system according to any one of the preceding claims, characterised in that the bridge resistances (125, 135) of the two measuring bridges (120, 130) in each case have identical resistance values.

9. Measuring system according to any one of the preceding claims, characterised in that the reference resistances (150) correspond to the wave resistance of the system (50) to be measured.

10. Measuring system according to any one of the preceding claims, characterised in that, in order to convert their balanced output signals into unbalanced signals relative to earth, the two measuring bridges (20, 30, 120, 130) are connected to balancing transmitters (160) of which the output lines (165) are connected to the measuring channel inputs.

11. Measuring system according to Claim 10, characterised in that isolation amplifiers (166) are connected between measuring bridges (120, 130) and further processing switching elements for reverse isolation.

12. Measuring system according to any one of the preceding claims, characterised in that the outputs of the isolation amplifiers (166) are guided to mixers (170) of which the driving inputs (171) are if necessary connected via further isolation amplifiers (185) to the output connections of a resistive power divider (180) of which the input (181) is acted upon by a frequency offset by an intermediate frequency.

13. Measuring head for a broadband measuring system for network analysis, characterised in that it contains two identically constructed measuring bridges (120, 130) with directivity properties, the one measuring bridge (120) being connected on the output side to an object to be measured and the other measuring bridge (130) being connected on the input side to the high-frequency output of a tunable high-frequency sweep generator (1) and with their outputs connected on the one hand to the reference input of a network analyser and on the other hand to the input of the first measuring bridge.

14. Measuring head according to Claim 13, characterised in that all the connection elements, such as cables (100), strip lines and the like, are secured in the measuring head housing.

## Revendications

1. Système de mesure à large bande pour l'analyse des réseaux électriques, comprenant :
- un générateur-vobulateur H.F. (1) à fréquence modulée par voie électronique, comportant au moins une sortie (2),
- un analyseur de réseau (3) qui,
-- outre une entrée de signal de référence (4), comporte au moins une première entrée de canal de mesure (5) et éventuellement d'autres entrées de canal de mesure (6) et
- un agencement de circuit (7)
-- qui est connecté au moyen d'éléments de liaison de type coaxial (câbles, prises et analogues) entre la sortie (2) du générateur H.F. (1) et les entrées (4, 5, 6) de l'analyseur de réseau (3) et
-- qui contient un circuit répartiteur dont une entrée (9) est reliée à la sortie (2) du générateur H.F. (1) et comporte deux bornes de sortie (10, 11) dont une première est reliée à l'entrée de signal de référence (4) de l'analyseur de réseau (3) et
-- contient en outre un premier pont de mesure (20) à propriétés de redressement dont les entrées/sorties (21, 22, 23) ont des découplages différents, dont l'entrée (21) est reliée à une sortie (11) du circuit répartiteur et dont une première sortie (23) est reliée à un objet à mesurer (50), par exemple un passe-bande,
caractérisé en ce que :
- le circuit répartiteur est formé d'un second pont de mesure (30) à propriétés de redressement dont un découplage élevé (24) est situé entre les deux bornes de sortie (10, 11).

2. Système de mesure selon la revendication 1, caractérisé en ce que les deux ponts de mesure (20, 30) de l'agencement de circuit (7) ont des propriétés de redressement identiques.

3. Système de mesure selon l'une des revendications précédentes 1 et 2, caractérisé en ce que les découplages entre les sorties/entrées des deux ponts de mesure (20, 30) sont égaux respectivement à 46 dB / 8 dB / 6 dB.

4. Dispositif selon l'une des revendications précédentes, caractérisé en ce qu'une seconde sortie (22) du premier pont de mesure (20) est reliée à l'autre entrée de canal de mesure (5) de l'analyseur de réseau (3).

5. Système de mesure selon l'une des revendications précédentes, caractérisé en ce que les deux ponts de mesure (20, 30, 120, 130) sont disposés, éventuellement avec d'autres composants, dans un boîtier (40) commun.

6. Système de mesure selon la revendication 5, caractérisé en ce que le boîtier (40) comporte au moins une sortie de mesure (123) qui est agencée de façon à pouvoir être raccordée directement à l'objet à mesurer (50).

7. Système de mesure selon l'une des revendications précédentes, caractérisé en ce que l'ensemble des composants des deux ponts de mesure (120, 130), ainsi que les autres composants disposés dans le boîtier de tête de mesure sont disposés d'une manière symétrique vis-à-vis du plan médian longitudinal (200) d'une platine portant les composants.

8. Système de mesure selon l'une des revendications précédentes, caractérisé en ce que les résistances de pont (125, 135) des deux ponts de mesure (120, 130) ont respectivement des valeurs identiques de résistance.

9. Système de mesure selon l'une des revendications précédentes, caractérisé en ce que les résistances de référence (150) sont égales à l'impédance caractéristique du système à mesurer (50).

10. Système de mesure selon l'une des revendications précédentes, caractérisé en ce qu'en vue de la transformation de leurs signaux de sortie symétriques en signaux chacun dissymétriques vis-à-vis de la masse, les deux ponts de mesure (20, 30, 120, 130) sont reliés à des convertisseurs de symétrie (160) dont des conducteurs de sortie (165) sont reliés aux entrées de canal de mesure.

11. Système de mesure selon la revendication 10, caractérisé en ce que des amplificateurs d'isolation (166) sont connectés en vue de l'isolation inverse entre les ponts de mesure (120, 130) et des éléments de circuit de traitement ultérieur.

12. Système de mesure selon l'une des revendications précédentes, caractérisé en ce que les sorties des amplificateurs d'isolation (166) sont reliées à des mélangeurs (170) dont des entrées d'attaque (171) sont reliées, éventuellement par l'intermédiaire d'autres amplificateurs d'isolation (185), aux bornes de sortie d'un répartiteur de tension de type résistif (180) dont une entrée (181) est soumise à une fréquence décalée d'une fréquence intermédiaire.

13. Tête de mesure pour un système de mesure à large bande pour l'analyse des réseaux électriques, caractérisée en ce qu'elle contient deux ponts de mesure (120, 130) de strucure identique, à propriétés de redressement, le premier pont de mesure (120) étant relié du côté de sortie à un objet à mesurer et l'autre pont de mesure (130) étant relié du côté d'entrée à la sortie H.F. d'un générateur-vobulateur H.F. (1) à fréquence modulée et, par ses sorties, d'une part à une entrée de référence d'un analyseur de réseau et d'autre part à l'entrée du premier pont de mesure.

14. Tête de mesure selon la revendication 13, caractérisé en ce que tous les éléments de liaison, tels que câbles (100), conducteurs-rubans et analogues, sont fixés dans le boîtier de tête de mesure.
